(19)

Europäisches
Patentamt
European
Patent Office
Office européen
des brevets

(11)  **EP 1 894 981 A1**

(12)  **EUROPEAN PATENT APPLICATION**

(43) Date of publication:
**05.03.2008  Bulletin 2008/10**

(51) Int Cl.:
**C09J 7/02** (2006.01)

(21) Application number: **07015826.6**

(22) Date of filing: **10.08.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority:  **29.08.2006  JP  2006232732**

(71) Applicant: **Nitto Denko Corporation**
**Ibaraki-shi,**
**Osaka 567-8680 (JP)**

(72) Inventors:
 • **Miki, Tsubasa**
   **Ibaraki-shi**
   **Osaka 567-8680 (JP)**
 • **Asai, Fumiteru**
   **Ibaraki-shi**
   **Osaka 567-8680 (JP)**

 • **Takahashi, Tomokazu**
   **Ibaraki-shi**
   **Osaka 567-8680 (JP)**
 • **Sasaki, Takatoshi**
   **Ibaraki-shi**
   **Osaka 567-8680 (JP)**
 • **Shintani, Toshio**
   **Ibaraki-shi**
   **Osaka 567-8680 (JP)**
 • **Yamamoto, Akiyoshi**
   **Ibaraki-shi**
   **Osaka 567-8680 (JP)**

(74) Representative: **Hager, Thomas Johannes**
   **Hoefer & Partner**
   **Patentanwälte**
   **Pilgersheimer Strasse 20**
   **81543 München (DE)**

(54)  **Adhesive sheet for water jet laser dicing**

(57)     An adhesive sheet for water jet laser dicing, comprises an adhesive layer laminated on a base film, wherein the adhesive sheet has perforations, has a porosity of 3 to 90%. and has a fracture elongation of at least 100%.

Fig.1a

EP 1 894 981 A1

**Description**

BACKGROUND OF THE INVENTION

1. Field of the Invention

The present invention relates to an adhesive sheet for water jet laser dicing, and more particularly relates to an adhesive sheet for water jet laser dicing used to fix a semiconductor wafer and/or a semiconductor-related material during dicing with a water jet laser.

2. Background Information

The conventional practice has been to use a rotary blade known as a dicing blade to cut semiconductor wafers, semiconductor-related materials and the like, and separate them into chips and IC parts. In this dicing step, the semiconductor wafer or the like is usually affixed with an adhesive tape to fix it in place. After the semiconductor wafer or the like has been cut into chips, they are removed from the adhesive tape by a pick-up.

However, physical stress produced by the dicing blade can cause die fly-off in the chips and the like cut by this method, or cause cracking, chipping, and other such defects, which lowers the quality of the chips and the like, and also lowers the efficiency of this cutting method. This problem has become more serious as there has been greater demand for even smaller and thinner electronic devices in recent years.

In view of this, a dicing method that makes use of a laser beam, and particularly a method for processing materials by cutting, perforating, welding, stamping, peeling, or the like using a laser beam guided by a liquid jet, has been proposed as an alternative to techniques for cutting semiconductor wafers and the like with a dicing blade (see WO95/32834, for example). With this method, the wafer or the like is merely exposed to a water jet from above, which prevents die fly-off and the like caused by the physical stress produced by a rotating blade.

Also, with a cutting method that makes use of this laser technique, the use of a water jet can be a problem in that it makes the chips or the like more susceptible to coming loose from the adhesive tape that fixes them, and in an effort to deal with this, an adhesive tape has been proposed that can be used preferably in water jet laser dicing (see Japanese Laid-Open Patent Application 2001-316648, for example).

However, even with an adhesive tape that can be used preferably in water jet laser dicing, when the chips or the like are removed from the adhesive sheet by pick-up after dicing, sometimes not enough space can be left between adjacent chips if the expandability of the adhesive sheet itself is inadequate, and this again can lead to cracking, chipping, and the like in the chips.

SUMMARY OF THE INVENTION

It is an object of the present invention to provide an adhesive sheet with which adequate expandability can be obtained in pick-up after dicing, while maintaining the transmissivity of the liquid used in the liquid jet in water jet laser dicing, and extremely thin semiconductor wafers or materials can be machined without causing chipping or other such defects in the removal of the chips, IC parts, or the like.
The present invention provides an adhesive sheet for water jet laser dicing, comprising an adhesive layer laminated on a base film,
wherein the adhesive sheet has perforations, has a porosity of 3 to 90% and has a fracture elongation of at least 100%.

According to the present invention, it is possible to provide an adhesive sheet with which adequate expandability can be obtained in pick-up after dicing, while maintaining the transmissivity of the liquid used in the liquid jet in water jet laser dicing. As a result, enough space can be obtained between adjacent chips in the removal of the chips, IC parts, or the like, thus, extremely thin semiconductor wafers or materials can be machined without causing chipping or other such defects occurred by contact between chips, impact by a pick-up or the like

The adhesive sheet for water jet laser dicing of the present invention can be utilized in a wide range of applications in which a material is diced with a laser beam guided by a liquid jet, that is, it can be applied not only to semiconductor-related materials and the like (such as semiconductor wafers, BGA packages, printed wiring boards, ceramic boards, glass member for liquid crystal devices, sheet materials, circuit boards, glass substrates, ceramics substrates, metal substrates, light-emitting and light-receiving element substrates for semiconductor laser, MEMES substrates, semiconductor packages), but to all kinds of materials.

BRIEF DESCRIPTION OF THE DRAWINGS

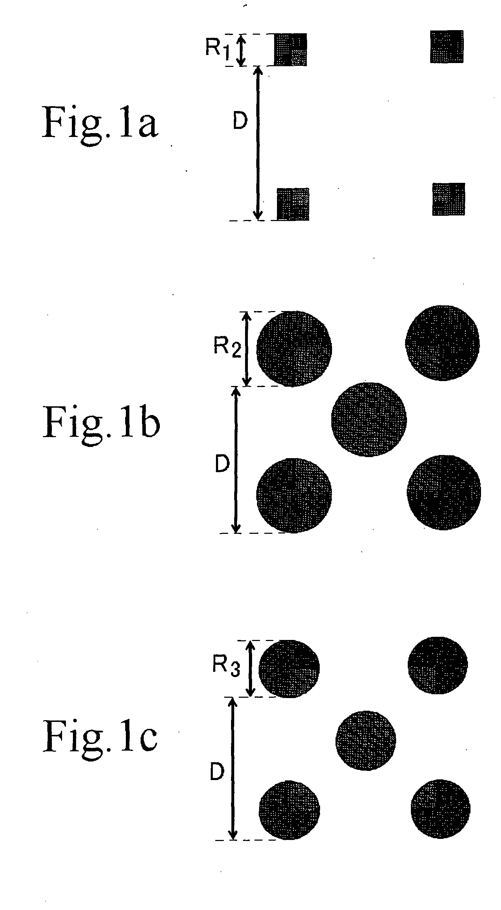

Figs. 1a to 1c are simplified views showing patterns of perforations in the adhesive sheet for water jet laser dicing of the present invention.

## DETAILED DESCRIPTION OF THE PREFERRED EMBODIMENTS

The adhesive sheet for water jet laser dicing of the present invention mainly comprises a base film and an adhesive layer disposed on this base film. The phrase "adhesive sheet for water jet laser dicing" here refers to an adhesive sheet that is used in dicing with a laser beam guided by a liquid jet (usually a water jet), and with which the liquid used in this liquid jet during dicing, such as a liquid jet with at least a specific pressure, and the liquid that is applied directly or indirectly from the adhesive layer side can escape from one side of the adhesive sheet to the other side. The specific pressure here is usually about a few MPa or higher.

The adhesive layer comprises an adhesive coated on one side of the base film. This adhesive may be any type of pressure sensitive, heat-sensitive, photosensitive, but it is suitably a type that is cured by an energy radiation, because this allows the layer to be easily removed from the workpiece. The energy radiation used here can be radiation of various wavelengths, such as ultraviolet rays, visible light rays, or infrared rays, but since the laser beam used for dicing is one with an oscillation wavelength less than 400 nm, such as a third or fourth harmonic of a YAG laser with an oscillation wavelength of 355 nm or 266 nm, XeCl excimer laser with an oscillation wavelength of 308 nm, or KrF excimer laser with an oscillation wavelength of 248 nm, or one with an oscillation wavelength greater than 400 nm, such as a titanium sapphire laser with a wavelength near 750 to 800 nm, which allows light absorption in the UV band via a multi-photon absorption process, which allows cutting at a width of 20 $\mu$m or less by multi-photon absorption ablation, and which has a pulse width of 1 $e^{-9}$ second or less, it is preferable to use an adhesive that will not be cured by a irradiation with the laser beam of the dicing apparatus being used.

A known adhesive including (meth)acrylic polymers and rubber-based polymers can be used as the material that forms the adhesive layer, but a (meth)acrylic polymer is particularly preferable because even when a photosensitive adhesive is formed, it can be cured without adding any special monomer/oligomer component or the like for an energy radiation curing.
Examples of rubber-based polymers include natural rubbers, such as polyisoprene; and synthetic rubbers, such as styrene-butadiene rubber or a rubber based on polybutadiene, butadiene-acrylonitrile, chloroprene and the like.

Examples of a monomer component of (meth)acrylic polymers include alkyl acrylates and alkyl methacrylates having linear or branched alkyl groups with 30 or fewer carbons, and preferably 4 to 18 carbons, such as methyl, ethyl, n-propyl, isopropyl, n-butyl, t-butyl, isobutyl, pentyl, isopentyl, hexyl, cyclohexyl, heptyl, 2-ethylhexyl, octyl, isooctyl, nonyl, isononyl, decyl, isodecyl, undecyl, rauryl, tridecyl, tetradecyl, stearyl, octadecyl, and dodecyl. These alkyl (meth) acrylates can be used alone or as mixture of more than two components.

Examples of a monomer component other than the above monomers include carboxyl-containing monomer such as acrylic acid, methacrylic acid, carboxyethyl (meth)acrylate, carboxypentyl (meth)acrylate, itaconic acid, maleic acid, fumaric acid, and crotonic acid; acid anhydride monomer such as maleic anhydride, itaconic anhydride; hydroxyl group-containing monomer such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydodecyl (meth)acrylate, 12-hydroxyrauryl (meth)acrylate, 4-hydroxymethyl cyclohexyl methyl(meth)acrylate; sulfonate-containing monomer such as styrenesulfonate, allylsulfonate, 2-(meth) acrylamide-2-methyl propanesulfonate, (meth)acrylamide propanesulfonate, sulfopropyl (meth)acrylate, (meth)acryloyl oxynaphthalenesulfonate; phosphate-containing monomer such as 2-hydroxyethyl acryloylphosphate; (meth)acrylamide; N-hydroxymethylamide (meth)acrylate; alkylamino alkylester(meth) acrylate such as dimethylamino ethylmethacrylate, t-butylamino ethylmethacrylate; N-vinylpyrrolidone; acryloyl morpholine; vinyl acetate; styrene; acrylonitrile and the like. These monomer components can be used alone or as mixture of more than two components.

Multifunctional monomers may be added as needed for the purpose of crosslinking (meth)acrylic polymer. Examples of the multifunctional monomer include 1,6-hexanediol di(meth)acrylate, polyethylene glycol di(meth)acrylate, polypropylene glycol di(meth)acrylate, neopentylglycol di(meth)acrylate, pentaerythritol di(meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, epoxy(meth)acrylate, polyester (meth)acrylate, urethane (meth)acrylate and the like. These multifunctional monomer components can be used alone or as mixture of more than two components. From the standpoint of adhesion characteristic and the like, the amount in which the multifunctional monomers are contained is preferably no more than 30 wt%, more preferably no more than 20 wt% of the total monomer component.
It is even more preferable to use a monomer and/or oligomer having an energy radiation curable functional group, such as a carbon-carbon double bond.

Examples of the monomer and/or oligomer include urethane (meth)acrylate, trimethylolpropane tri(meth)acrylate, pentaerythritol tri(meth)acrylate, pentaerythritol tetra(meth)acrylate, dipentaerythritol monohydroxy penta(meth) acrylate, dipentaerythritol hexa(meth)acrylate, 1,4-butylene glycol di(meth)acrylate and the like. These components can be used alone or as mixture of more than two components.

There are no particular restrictions on the amount in which these are contained, but from the standpoint of adhesion characteristic, about 5 to 500 weight parts, or about 70 to 150 weight parts per 100 weight parts of the (meth)acrylic polymer or other base polymer of the adhesive is preferable.

It is preferable to use a photopolymerization initiator when a photosensitive adhesive is formed. Examples of the photopolymerization initiator include acetophenone compounds such as 4-(2-hydroxyethoxy) phenyl(2-hydroxy-2-propyl) ketone, $\alpha$-hydroxy-$\alpha$,$\alpha$-methyl acetophenone, methoxy acetophenone, 2,2-dimethoxy-2-phenyl acetophenone, 2,2-diethoxy-acetophenone, 1-hydroxycyclohexyl phenyl ketone, 2-methyl-1-[4-(methyltio)phenyl]-2-morpholinoprophane-1; benzoine ether compounds such as benzoine ethyl ether, benzoine isopropyl ether, anisoin methyl ether; $\alpha$-ketol compounds such as 2-methyl-2-hydroxypropylphenon; ketal compounds such as benzyldimethyl keral; aromatic sulfonyl chloride compounds such as 2-naphthalene sulfonyl chloride; light-active oxime compounds such as 1-phenon-1, 1-propanedione-2-(o-ethoxycarbonyl) oxime; benzophenone compounds such as benzophenone, benzoylbenzoate, 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone; camphor chinone; ketone halide; acyl phosphinoxide; acyl phosphonate and the like. These components can be used alone or as mixture of more than two components. The amount in which the photopolymerization initiators are contained, about 0.1 to 10 weight parts, or about 0.5 to 5 weight parts per 100 weight parts of the base polymer of the adhesive is preferable.

A crosslinking agent may also be added to raise the weight average molecular weight of the base polymer. Examples of the crosslinking agent include polyisocyanate compounds, epoxy compounds, aziridine compounds, melamine resins, urea resins, anhydrous compounds, polyamines, carboxyl group-containing polymers and the like. These can be used alone or as mixture of more than two compounds. When a crosslinking agent is used, it is generally preferable for it to be used in an amount of about 0.01 to 5 weight parts per 100 weight parts base polymer so that the peeling-off adhesion strength will not decrease too much.

In addition to the above components, the adhesive may optionally comprise any conventional additive such as tackifiers, antioxidants, fillers, pigments and the like.

The acrylic polymer can be prepared, for example, by applying a known method such as solution polymerization, emulsion polymerization, mass polymerization, suspension polymerization to one or more kinds of monomer or a mixture thereof. Among these, solution polymerization is preferable. Examples of solvents that can be used include ethyl acetate, toluene and other such polar solvents. The solution concentration is usually about 20 to 80 wt%.

A polymerization initiator may be used in the preparation of the polymer. Examples of the polymerization initiator include peroxides such as hydrogen peroxide, benzoyl peroxide, t-butyl peroxide, and the like. One may be used by itself, or it may be combined with a reducing agent and used as a redox type of polymerization initiator. Examples of the reducing agent include ionic salts such as salts of iron, copper, cobalt, sulfite, bisulfite; amines such as triethanol amine; reducing sugar such as aldose, ketose and the like. Also, azo compounds such as 2,2'-azobis-2-methylpropioamidine salt, 2,2'-azobis-2,4-dimethylvaleronitrile, 2,2'-azobis-N,N'-dimethyleneisobutylamidine salt, 2,2'-azobisisobutyronitrile, 2,2'-azobis-2-methyl-N-(2-hydroxyethyl) propionamide may be used. These can be used alone or as mixture of more than two components.

The reaction temperature is usually about 50 to 85°C, and the reaction time about 1 to 8 hours. From the standpoint of preventing fouling of the workpiece and the like, it is preferable for the acrylic polymer to have a low content of low-molecular weight substances, and for the acrylic polymer to have a number average molecular weight of at least 300,000, particularly at a rage of about 800,000 to 3,000,000.

The thickness of the adhesive layer can be suitably adjusted within a range in which the layer will not come off the workpiece, but from the standpoints of ensuring adequate adhesive strength, preventing undesirable adhesive residue from remaining on the back of the semiconductor wafer or the like after the wafer or the like has been removed from the tape, and allowing water to pass through easily by cutting the adhesive layer, the thickness is usually less than about 300 $\mu$m, preferably about 1 to 200 $\mu$m, about 1 to 50 $\mu$m, about 3 to 20 $\mu$m. This minimizes resonance of the adhesive layer caused by vibration attributable to the liquid jet or irradiation with the laser beam during dicing, allows the oscillation amplitude to be suppressed, and prevents cracking, chipping, and the like of the chips. It also allows the workpiece to be securely fixed during dicing.

As discussed below, the adhesive layer may include perforations as the base film does. These perforations can be formed by any of the methods discussed below for the base film. It is preferable, though, to form these perforations simultaneously with the perforations in the base film because they will then go all the way through from the base film to the adhesive layer, that is, the perforations in the base film overlap with the perforations in the adhesive layer. To put this another way, it is preferable for the perforations in the base film and the perforations in the adhesive layer to have substantially the same size and shape, and to be formed in substantially the same locations.

Examples of the base film include non-woven, woven and the like made of a synthetic resin film, for example, polyolefins such as polyethylene, polypropylene (e.g., low-density polyethylene, liner low-density polyethylene, high-density polyethylene, drawn polypropylene, non-drawn polypropylene, ethylene-polypropylene copolymer, ethylene-vinyl acetate copolymer, ethylene-(meth)acrylic acid copolymer, ethylene-(meth)acrylic ester copolymer and the like), polyethylene terephthalate, polyurethane, EVA, polytetrafluoroethylene, polyvinyl chloride, polyvinylidene chloride, polyamide, acetal resin, polystyrene, polycarbonate, fluorocarbon polymer; rubber-containing polymer such as styrene-butadiene copolymer; polymer fiber such as PP, PVC, PE, PU, PS, PO, PET and the like; synthetic fiber such as rayon, acetylcellulose and the like; natural fiber such as cotton, silk, wool and the like; inorganic fiber such as glass fiber, carbon fiber and the like. These can be used single layer or multilayer of more than two layers. Among these, a layer made of or comprising polyolefins is preferable. As a result, both adequate strength and expandability for laser dicing can be ensured for the adhesive sheet.

The base film may be subjected to surface treatment, such as corona discharge treatment, flame treatment, plasma treatment, sputter etching treatment, undercoating (e.g., primer), fluorine treatment; or degreasing treatment using a chemical solution on the surface thereof on which the adhesive film is formed, for the enhancement of the adhesiveness to the adhesive film. Applying a primer is especially preferable. The thickness of the base film is generally 10 to 400 $\mu$m, preferably 30 to 250 $\mu$m, for avoiding fracture or breaking of the sheet during processing the semiconductor wafer or the like as well as decreasing manufacturing cost.

The adhesive sheet of the present invention can be formed by a tape manufacturing method known in this field of technology. For example, the base film is provided first. The adhesive, then, can be laminated onto the base film. The base film may be coated directly, or a transfer coating process may be employed in which a process material coated with a release agent is coated with the adhesive and dried, after which the adhesive is laminated to the base film, or the adhesive may be laminated in a rolling mill on the base film. These coating process can be performed by any existing coating method, for example, reverse roll coating, gravure coating, curtain spray coating, die coating, extrusion and other industrially applied coating methods may be used. The base film that is prepared may have perforations already in the base film, or the perforations may be formed after the base film has been coated with the adhesive.

The adhesive sheet which is constituted by the adhesive layer laminated on the base film possesses perforations which are perforated in the thickness direction of the base film or which is connected plural perforations. The perforations may be regularly or irregularly provided on the adhesive sheet. When the material of the base film comprises fibers, the perforations maybe obtained naturally as a result of the fiber-fiber interstices, thus, rendering the base film porous. Apart from the such perforations, it is good for there to be perforations that substantially overlap with the perforations formed in the adhesive layer. This allows water to escape from one side of the adhesive sheet to the other side, regardless of the hydraulic pressure of the liquid jet, and prevents the chips from coming loose, etc.

The adhesive sheet can be perforated by a variety of through-hole making methods. Examples include a mechanical and/or a thermal method. Examples of how the perforations are made in the base film include water jet processing, laser processing, and punching with a press (such as a Thompson press) or a rotary roll (such as a punching machine or a rotary roll equipped with needles).

The shape and size of the perforations of the adhesive sheet are not limited as long as it ensures water-permeability, for example, the shape may be irregular as in the case of the fiber-fiber interstices, and the perforations of square (e.g., Fig 1a), circular (e.g., Figs 1b and 1c), triangular, rhombic, star-like or other shape may be regularly disposed. The size of the perforations as measured by microscope is usually 3.0 mm$^2$ or less, preferably 10 $\mu$m$^2$ to 3.0 mm$^2$, 0.001 to 3.0 mm$^2$, more preferably 0.1 to 2.0 mm$^2$, most preferably 0.2 to 1.1 mm$^2$. If the perforations are square, triangular or rhombic shape, the perforation size may preferably be 5 $\mu$m to 1.40 mm, 0.30 to 1.40 mm, more preferably 0.45 to 1.00 mm in length on a side (e.g., $R_1$ in Fig.1a). If the perforations are circular in shape, the perforation size may preferably be 5 $\mu$m to 0.80 mm, 0.17 to 0.80 mm, more preferably 0.25 to 0.59 mm in diameter (e.g., $R_2$ and $R_3$ in Figs. 1b and 1c). The perforation density is preferably more than 100,000 holes/m$^2$, more preferably 300,000 to 700,000 holes/m$^2$. The perforation density is calculated from the pitch distance in length direction and transverse direction (e.g., D in Figs.1a to 1c).

The adhesive sheet preferably has a porosity of about 3 to 90%, preferably about 3 to 60 %, about 10 to 55 %, about 20 to 50 %. As a result, the water permeability is good, and the separation of the chips from the adhesive sheet and/or the admixture of foreign matter between the sheet and the chips can be prevented. Also, good mechanical strength is ensured in the sheet, a decrease in the smoothness of the sheet is prevented, and a secure bond can be achieved between the base film and the adhesive. In this case, the porosity is calculated from the perforation size and the perforation density, i.e.

$$\text{porosity (\%)} = (\text{perforation size}) \times (\text{perforation density}) \times 100.$$

The adhesive sheet of the present invention preferably has an elongation of over 100%, and more preferably 150%. This is because stretching the adhesive sheet makes it possible for the chips or the like to be easily picked up from the adhesive sheet after the dicing step.

Furthermore, the adhesive sheet preferably has a tensile strength of over 0.1 N/10 mm, more preferably over 0.3 N/10 mm. The reason for this is to avoid breaking and/or cutting the adhesive sheet itself.

The elongation percentage and tensile strength can be measured, for example, with a tensile tester using a sample with a length of 5.0 cm and a width of 20 mm. The tensile speed during the test is 300 mm/minute at room temperature (according to ASTM D1000). The elongation percentage can be calculated as follows.

$$\text{Elongation (\%)} = (\text{Fracture Length} - \text{Original Length}) \div (\text{Original Length}) \times 100$$

The tensile strength is a value at fracturing.

The adhesive sheet of the present invention has an adhesive strength of at least 1.5 N/20 mm, preferably at least 3 N/20 mm, and less than 10 N/20 mm, preferably less than 8 N/20 mm. In other words, along with changes in dicing technology to technology involving the use of a water jet laser, the critical significance of the adhesive strength of an adhesive sheet used for dicing is also changing, and as a result, good adhesion with the wafer or the like during dicing can be ensure even at a weaker adhesive strength, and chips or parts can be prevented from coming loose from the adhesive tape. In addition, a reduction in the initial adhesive strength allows chipping and other such defects to chips, IC parts, and the like during pick-up to reduce. In particular, in the case of a photosensitive adhesive, the adhesive strength of the adhesive after irradiation can be effectively, quickly, and easily reduced. The adhesive strength after irradiation is preferably less than 0.2 N/20 mm, more preferably less than 0.18 N/20 mm.

Here, an adhesive strength is the value which is measured on an Si-mirror wafer under the conditions of 23 ± 3 °C, 180 ° peeling angle and a peeling speed of 300 mm/min (according to ASTM D1000)..

Examples of the adhesive sheet for water jet laser dicing of the present invention will now be described in detail.

Example1

An acrylic adhesive composed of 100 parts acrylic copolymer, 30 parts plasticizer, and 10 parts crosslinking agent was used to coat one side of a 50 μm process liner in a thickness 15 μm, after which the coating was dried for 3 minutes at 100°C. After drying, the coating side was immediately applied to a base film (a blended film of EVA (vinyl content of 9 %) and polyethylene (blend ratio (wt%) of EVA : polyethylene = 30:70)) to obtain an adhesive sheet.

Perforations were made in the film thus produced by thermal machining using a laser with a wavelength of 1064 nm and a laser boring apparatus M4350 (made by esi), which gave an adhesive sheet for semiconductor wafer processing. Circular perforations with an area of 0.2 mm$^2$ were made so that the spacing D of the perforations in FIG. 1b was 1 mm.

Example 2

An acrylic adhesive composed of 100 parts acrylic copolymer, 30 parts plasticizer, and 10 parts crosslinking agent was used to coat one side of a 50 μm process liner in a thickness 15 μm, after which the coating was dried for 3 minutes at 100°C. After drying, the coating side was immediately applied to a base film (a blended film of EVA (vinyl content of 9%) and polyethylene (blend ratio (wt%) of EVA : polyethylene = 30:70)) to obtain an adhesive sheet.

The above-mentioned film was machined with a precision film punching machine (RFP-S20, made by UHT), which gave an adhesive sheet for semiconductor wafer processing in which circular perforations with an area of 0.2 mm$^2$ were made so that the spacing D of the perforations in FIG. 1 b was 1 mm.

Example 3

An acrylic adhesive composed of 100 parts acrylic copolymer, 30 parts plasticizer, and 10 parts crosslinking agent was used to coat one side of a 50 μm process liner in a thickness 15 μm, after which the coating was dried for 3 minutes at 100°C. After drying, the coating side was immediately applied to a base film (a blended film of EVA (vinyl content of 9%) and polyethylene (blend ratio (wt%) of EVA : polyethylene = 30:70)) to obtain an adhesive sheet.

A rotary roll equipped on its surface with hollow needles for making perforations was used, which gave an adhesive sheet for semiconductor wafer processing in which circular perforations with an area of 0.2 mm$^2$ were made so that the spacing D of the perforations in FIG. 1b was I mm.

Example 4

An acrylic adhesive composed of 100 parts acrylic copolymer, 30 parts plasticizer, and 10 parts crosslinking agent was used to coat one side of a 50 $\mu$m process liner in a thickness 15 $\mu$m, after which the coating was dried for 3 minutes at 100°C. After drying, the coating side was immediately applied to a base film (a blended film of EVA (vinyl content of 9%) and polyethylene (blend ratio (wt%) of EVA : polyethylene = 30:70)) to obtain an adhesive sheet.
The above-mentioned film was continuously pressed by using a Thompson press mold, which gave an perforated film for processing semiconductor wafers in which circular perforations with an area of 0.2 mm$^2$ were made so that the spacing D of the perforations in FIG. 1b was 1 mm.

Comparative Example 1

An acrylic adhesive composed of 100 parts acrylic copolymer, 30 parts plasticizer, and 10 parts crosslinking agent was used to coat one side of a 50 $\mu$m process liner in a thickness 15 $\mu$m, after which the coating was dried for 3 minutes at 100°C.
The coating side of the above-mentioned acrylic adhesive was applied to a base film (porosity of 30%) produced by making perforations of 0.1 to 0.3 mm in a non-woven cloth composed of polypropylene fiber, which gave an adhesive sheet.

Comparative Example 2

An acrylic adhesive usually using for processing silicon wafer utilizing rotary diamond blade method was used to coat a 70$\mu$m standard PVC film in a thickness 10 $\mu$m, and thus obtaining an adhesive sheet.
(Dicing conditions)
Die fry-off rate (chip fly rate, %) is calculated at dicing semiconductor chips in the following conditions.
Laser wavelength: 532 nm
Dicing speed: 50 mm/s
Laser diameter: 50 $\mu$m
Water jet pressure: 40 MPa
Chip size: 3 mm $\times$ 3 mm
Wafer size: 13.7 cm (5 inch)
Wafer thickness: 150 $\mu$m.
The results are shown in Table 1.
Table 1

| | Adhesive | Base Film | Perforating Method | Tensile strength | Fracture Elongation | Porosity | Chip Fly-Off |
|---|---|---|---|---|---|---|---|
| Ex.1 | Acrylic | Olefin | Laser | MD 28N/ 10mm TD 28N/ 10mm | MD 305% TD 321% | 31~ 45% | 0% |
| Ex.2 | Acrylic | Olefin | Punching Machine | MD 28N/ 10mm TD 28N/ 10mm | MD 305% TD 321% | 31~ 45% | 0% |
| Ex.3 | Acrylic | Olefin | Rotary Roll with Needles | MD 28N/ 10mm TD 28N/ 10mm | MD 305% TD 321 % | 31 ~ 45% | 0% |
| Ex.4 | Acrylic | Olefin | Thompson Press | MD 28N/ 10mm TD 28N/ 10mm | MD 305% TD 321% | 31 ~ 45% | 0% |

(continued)

|  | Adhesive | Base Film | Perforating Method | Tensile strength | Fracture Elongation | Porosity | Chip Fly-Off |
|---|---|---|---|---|---|---|---|
| Comp. Ex.1 | Acrylic | PP non-woven cloth |  | MD 120N/ 10mm TD 35N/ 10mm | MD 42% TD 43% | 30% | 22% |
| Comp. Ex.2 | Acrylic | PVC |  | MD 60.5N/ 10mm TD 55.8N/ 10mm | MD 312% TD 323% | 0% | 47% |

Tensile strength and fracture elongation were measured as follows. Samples of 30 mm × 10 mm were taken, taking three each in the machine and transverse directions, the fracture elongation was measured at a pulling rate of 300 mm/minute with an ordinary tensile strength tester (Tensilon), and the average value thereof was termed the tensile strength.

As is clear from Table 1, when perforations were made in the adhesive sheet, that is, when perforations were formed that were substantially aligned all the way through from the adhesive layer to the base film, and when porosity is set at predetermined value, the water originating in the water jet could easily go through the adhesive sheet, and chip fly-off could be effectively prevented. Also, since the fracture elongation was ensured at a suitable value, there was good expansion during pick-up after dicing, and no defects were caused by pick-up.

Meanwhile, in Comparative Example 1, because the fracture elongation was low, the adhesive sheet split when it expanded. Also, since the perforations in the base film and the adhesive layer did not line up all the way through, water did not pass through well and chip fly-off occurred.

With Comparative Example 2, because the water could not pass through the adhesive sheet, either dicing itself could not be performed well, or the water did not pass through and chip fly-off occurred.

This application claims priority to Japanese Patent Application No. 2006-232732. The entire disclosure of Japanese Patent Application No. 2006-232732 is hereby incorporated herein by reference.

While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims and their equivalents. Thus, the scope of the invention is not limited to the disclosed embodiments.

**Claims**

1. An adhesive sheet for water jet laser dicing, comprising an adhesive layer laminated on a base film, wherein the adhesive sheet has perforations, has a porosity of 3 to 90% and has a fracture elongation of at least 100%.

2. The adhesive sheet according to Claim 1, wherein the perforations are penetrated from the base film to adhesive layer.

3. The adhesive sheet according to Claim 1, wherein the base film includes a layer composed of polyolefin.

4. The adhesive sheet according to Claim 1, wherein the perforations have a diameter of 5 to 800 $\mu$m.

5. The adhesive sheet according to Claim 1, wherein the perforations are from 10 $\mu$m$^2$ to 3.0 mm$^2$ in size.

6. The adhesive sheet according to Claim 1, wherein the adhesive is a rubber-based or acrylic-based adhesive.

7. The adhesive sheet according to Claim 1, wherein the adhesive sheet has a tensile strength of over 0.1 N/10 mm.

Fig.1a

$R_1$

D

Fig.1b

$R_2$

D

Fig.1c

$R_3$

D

European Patent Office

## EUROPEAN SEARCH REPORT

Application Number

EP 07 01 5826

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 63 136527 A (NIPPON ELECTRIC CO) 8 June 1988 (1988-06-08) * abstract * | 1-7 | INV. C09J7/02 |
| X | JP 02 112258 A (SEIKO EPSON CORP) 24 April 1990 (1990-04-24) * abstract * | 1-7 | |
| X | JP 06 021220 A (SEIKO EPSON CORP) 28 January 1994 (1994-01-28) * abstract * | 1-7 | |
| X | JP 2005 239956 A (LINTEC CORP) 8 September 2005 (2005-09-08) * abstract * | 1-7 | |
| X | JP 11 151661 A (SPEEDFAM CO LTD) 8 June 1999 (1999-06-08) * the whole document * | 1-7 | |
| X | WO 2005/121268 A (LINTEC CORP [JP]; KATO KIICHIRO [JP]; TSUDA KAZUHIRO [JP]; MATSUBAYASH) 22 December 2005 (2005-12-22) * the whole document * | 1-7 | **TECHNICAL FIELDS SEARCHED (IPC)** <br><br> C09J |
| X | WO 2005/083024 A (LINTEC CORP [JP]; KATOH KIICHIRO [JP]; TSUDA KAZUHIRO [JP]; KANAZAWA 0) 9 September 2005 (2005-09-09) * the whole document * | 1-7 | |
| X | US 3 073 303 A (SCHAAR CHARLES H) 15 January 1963 (1963-01-15) * claims; figures; examples * | 1-7 | |
| X | US 2005/181164 A1 (PIUMARTA TIMOTHY [US] ET AL) 18 August 2005 (2005-08-18) * claims; figures * | 1-7 | |

-/--

The present search report has been drawn up for all claims

| Place of search | Date of completion of the search | Examiner |
|---|---|---|
| Munich | 7 December 2007 | Schmitz, Volker |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

**EUROPEAN SEARCH REPORT**

Application Number

EP 07 01 5826

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/083894 A1 (VETROVEC JAN [US] ET AL) 20 April 2006 (2006-04-20) * figures; examples * ----- | 1-7 | |
| A | EP 1 566 236 A (NITTO DENKO CORP [JP]) 24 August 2005 (2005-08-24) * claims; figures; examples * ----- | 1-7 | |

TECHNICAL FIELDS
SEARCHED        (IPC)

The present search report has been drawn up for all claims

| Place of search | Date of completion of the search | Examiner |
|---|---|---|
| Munich | 7 December 2007 | Schmitz, Volker |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 07 01 5826

This annex lists the patent family members relating to the patent documents cited in the above-mentioned European search report.
The members are as contained in the European Patent Office EDP file on
The European Patent Office is in no way liable for these particulars which are merely given for the purpose of information.

07-12-2007

| Patent document cited in search report | | Publication date | Patent family member(s) | | Publication date |
|---|---|---|---|---|---|
| JP 63136527 | A | 08-06-1988 | NONE | | |
| JP 2112258 | A | 24-04-1990 | NONE | | |
| JP 6021220 | A | 28-01-1994 | NONE | | |
| JP 2005239956 | A | 08-09-2005 | AU | 2005217263 A1 | 09-09-2005 |
| | | | CA | 2557409 A1 | 09-09-2005 |
| | | | CN | 1946821 A | 11-04-2007 |
| | | | EP | 1728842 A1 | 06-12-2006 |
| | | | WO | 2005083024 A1 | 09-09-2005 |
| | | | KR | 20060123595 A | 01-12-2006 |
| | | | US | 2007254136 A1 | 01-11-2007 |
| JP 11151661 | A | 08-06-1999 | NONE | | |
| WO 2005121268 | A | 22-12-2005 | AU | 2005252530 A1 | 22-12-2005 |
| | | | CA | 2570247 A1 | 22-12-2005 |
| | | | CN | 1984977 A | 20-06-2007 |
| | | | EP | 1767604 A1 | 28-03-2007 |
| | | | KR | 20070024711 A | 02-03-2007 |
| WO 2005083024 | A | 09-09-2005 | AU | 2005217263 A1 | 09-09-2005 |
| | | | CA | 2557409 A1 | 09-09-2005 |
| | | | CN | 1946821 A | 11-04-2007 |
| | | | EP | 1728842 A1 | 06-12-2006 |
| | | | JP | 2005239956 A | 08-09-2005 |
| | | | KR | 20060123595 A | 01-12-2006 |
| | | | US | 2007254136 A1 | 01-11-2007 |
| US 3073303 | A | 15-01-1963 | GB | 951468 A | 04-03-1964 |
| US 2005181164 | A1 | 18-08-2005 | NONE | | |
| US 2006083894 | A1 | 20-04-2006 | NONE | | |
| EP 1566236 | A | 24-08-2005 | CN | 1657584 A | 24-08-2005 |
| | | | JP | 2005236082 A | 02-09-2005 |
| | | | KR | 20060042991 A | 15-05-2006 |
| | | | US | 2005186709 A1 | 25-08-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9532834 A
- JP 2001316648 A
- JP 2006232732 A